# EUROPEAN PATENT APPLICATION

(11) **EP 3 522 234 A1**
(43) Date of publication of application: **07.08.2019**
(21) Application number: 18200161.0
(22) Date of filing: 12.10.2018
(51) Int. Cl.: H01L 31/0216

(54) **COLOR SOLAR CELL AND PREPARATION METHOD THEREOF**

(30) Priority: 31.01.2018 CN 201810095977
(71) Applicant: Beijing Apollo Ding Rong Solar Technology Co., Ltd., Beijing 100176 (CN)
(72) Inventor: Dechen, Liu, Beijing, Beijing 100176 (CN); Lihong, Yang, Beijing, Beijing 100176 (CN); Tao, Chen, Beijing, Beijing 100176 (CN); Xinlian, Li, Beijing, Beijing 100176 (CN)
(74) Representative: Cohausz & Florack

(57) **Abstract**

A color solar cell and a preparation method thereof are provided. The color solar cell (10) includes: a cell unit (20); and an anti-reflection layer (500) disposed on the cell unit (20) and configured to display a color pattern. By forming an anti-reflection layer (500) configured to display a color pattern on the cell unit (20), the color pattern effect of the solar cell is achieved, thereby avoiding the color of the solar cell from being monotonous. It helps beautify the appearance of the solar cell and improves its adaptability. Here, the anti-reflection layer (500) may be light-transparent, so as to ensure that light rays, such as sunlight, may penetrate and enter the cell unit (20) to realize photovoltaic conversion, thereby guaranteeing the power generation efficiency of the cell unit (20). The color solar cell (10) may not only meet the aesthetic requirements in building integration, but also meet the personalized customization requirements, and can better achieve the effect of exhibition and promotion.

## Description

### TECHNICAL FIELD

The present disclosure relates to a color solar cell and a preparation method thereof.

### BACKGROUND

Solar cell, which adopts photovoltaic technology therein, can realize photoelectric conversion effect and has broad application prospects. While realizing its basic power generation function, the solar cell is also widely used in new fields, such as an integration of photovoltaic and building, wearable devices, stained glasses, color walls, and etc. With the continuous development of photovoltaic market and people's aesthetics, requirements on the appearance of photovoltaic products have increased. The integration of photovoltaic and building requires diversity of products, especially the diversity of patterns and colors of its appearance, so as to achieve harmony, beauty and individuality of the environment and buildings. In addition, the unique and beautiful appearance also contributes to exhibition and promotion of the products. However, a thin-film cell chip prepared through a traditional method has a single blue-black color. After the thin-film cells are packaged as components, the color thereof is relatively monotonous, and the product differentiation is not obvious.

### SUMMARY

Based on this, with respect to the problems that the color of the thin-film cell chips is monotonous and the product differentiation is not obvious, it's necessary to provide a color solar cell and a preparation method thereof.

In an aspect, there is provided a color solar cell, comprising: a cell unit; and
an anti-reflection layer disposed on the cell unit and configured to display a color pattern.

In a possible implementation, the anti-reflection layer comprises: a first anti-reflection layer and a second anti-reflection layer; and
the first anti-reflection layer and the second anti-reflection layer present different colors.

In a possible implementation, a pattern corresponding to the first anti-reflection layer is different from a pattern corresponding to the second anti-reflection layer.

In a possible implementation, the pattern corresponding to the first anti-reflection layer is complementary to the pattern corresponding to the second anti-reflection layer.

In a possible implementation, a plurality of the cell units are provided; and
a sum of an area of the first anti-reflection layer and an area of the second anti-reflection layer is equal to an area of at least one of the cell units.

In a possible implementation, the anti-reflection layer further comprises: a third anti-reflection layer; and
the first anti-reflection layer, the second anti-reflection layer and the third anti-reflection layer present different colors.

In a possible implementation, a pattern corresponding to the first anti-reflection layer, a pattern corresponding to the second anti-reflection layer and a pattern corresponding to the third anti-reflection layer are complementary to each other.

In a possible implementation, a plurality of the cell units are provided; and
a sum of an area of the first anti-reflection layer, an area of the second anti-reflection layer and an area of the third anti-reflection layer is equal to an area of at least one of the cell units.

In a possible implementation, the first anti-reflection layer, the second anti-reflection layer and the third anti-reflection layer have different thicknesses.

In a possible implementation, the first anti-reflection layer, the second anti-reflection layer and the third anti-reflection layer are made of different materials.

In a possible implementation, the anti-reflection layer is made of SixNy, and a value range of x:y is 0.75∼4:1.

In a possible implementation, the cell unit comprises: a substrate and a function layer disposed on the substrate;
wherein the anti-reflection layer is disposed on the function layer.

In a possible implementation, the cell unit comprises: a substrate on which the anti-reflection layer is disposed; and
a function layer disposed on the anti-reflection layer.

In a possible implementation, the function layer comprises:
a back electrode layer disposed on the substrate;
a semiconductor layer disposed on the back electrode layer;
a conductive layer disposed on the semiconductor layer; and
a connection part penetrating through the semiconductor layer, one end of the connection part being electrically connected with the back electrode layer and the other end of the connection part being electrically connected with the conductive layer; wherein
the anti-reflection layer is disposed on the conductive layer.

In a possible implementation, the function layer comprises:
a back electrode layer disposed on the anti-reflection layer on the substrate;
a semiconductor layer disposed on the back electrode layer;
a conductive layer disposed on the semiconductor layer; and
a connection part penetrating through the semiconductor layer, one end of the connection part being electrically connected with the back electrode layer and the other end of the connection part being electrically connected with the conductive layer.

In a possible implementation, the semiconductor layer comprises:
a first semiconductor layer disposed on the back electrode layer; and
a second semiconductor layer disposed on the first semiconductor layer and in p-n bonding with the first semiconductor layer.

In a possible implementation, the connection part, when penetrating through the semiconductor layer, is in contact with or connected with the first semiconductor layer and the second semiconductor layer.

In a possible implementation, an intrinsic semiconductor layer is further disposed between the second semiconductor layer and the conductive layer, and the second semiconductor layer and the intrinsic semiconductor layer together constitute an n region of the cell unit.

In a possible implementation, the color solar cell further comprises: an electrode disposed on the anti-reflection layer and configured to conduct out charges generated by the cell unit.

In another aspect, there is provided a preparation method for a color solar cell, comprising:
providing a cell unit (S10); and
forming an anti-reflection layer on the cell unit, wherein the anti-reflection layer is configured to display a color pattern (S20).

In a possible implementation, forming an anti-reflection layer on the cell unit comprises:
providing a template having at least one hollowed-out pattern, and depositing the anti-reflection layer on the cell unit by taking the template as a shield.

In a possible implementation, providing a template and depositing the anti-reflection layer on the cell unit by taking the template as a shield comprises:
providing a first sub-template having at least one hollowed-out first sub-pattern, and depositing a first anti-reflection layer on the cell unit by taking the first sub-template as a shield (S201); and
providing a second sub-template having at least one hollowed-out second sub-pattern, and depositing a second anti-reflection layer on the cell unit by taking the second sub-template as a shield (S202); wherein
the first anti-reflection layer and the second anti-reflection layer present different colors.

In a possible implementation, the second sub-pattern is complementary to the first sub-pattern;
a plurality of the cell units are provided, and a sum of an area of the second sub-pattern and an area of the first sub-pattern is equal to an area of at least one of the cell units.

In a possible implementation, after step S202, the method further comprises:
providing a third sub-template having at least one hollowed-out third sub-pattern, and depositing a third anti-reflection layer on the cell unit by taking the third sub-template as a shield (S203); wherein
the first anti-reflection layer, the second anti-reflection layer and the third anti-reflection layer present different colors.

In a possible implementation, the first sub-pattern, the second sub-pattern and the third sub-pattern are complementary to each other;
a plurality of the cell units are provided, and a sum of an area of the first sub-pattern, an area of the second sub-pattern and an area of the third sub-pattern is equal to an area of at least one of the cell units.

In a possible implementation, a non-hollowed-out portion of the first sub-pattern is complementary to a sum of the area of the second sub-pattern and the area of the third sub-pattern.

In a possible implementation, the anti-reflection layer is formed through a chemical vapor deposition (CVD) process; and
a thickness of the anti-reflection layer is controlled by controlling the deposition rate or the deposition period of time.

In a possible implementation, step S10 comprises:
providing a substrate, forming a back electrode layer on a surface of the substrate, and performing a first etching on the back electrode layer to form a plurality of spaced back electrodes (S101);
depositing a semiconductor layer in spaces between adjacent back electrodes and on surfaces of the back electrodes, and performing a second etching on the semiconductor layer to enable the semiconductor layer to form a plurality of spaced semiconductor blocks, each of the semiconductor blocks being in contact with two of the back electrodes (SI02);
depositing a conductive material in spaces between adjacent semiconductor blocks and on surfaces of the semiconductor blocks to form a connection part and a conductive layer, wherein one end of the connection part is electrically connected with the conductive layer, and the other end of the connection part is electrically connected with the back electrode layer (SI03); and
performing a third etching on the conductive layer and the semiconductor layer to form a plurality of cell units connected in series (S104).

In a possible implementation, step S102 comprises:
forming a first semiconductor layer in spaces between the adjacent back electrodes and on the surfaces of the back electrodes (S1021);
forming a second semiconductor layer that is in p-n bonding with the first semiconductor layer on a surface of the first semiconductor layer (S1022); and
performing the second etching on the first semiconductor layer and the second semiconductor layer to form a plurality of the spaced semiconductor blocks, each of the semiconductor blocks being in contact with two of the back electrodes (S1023).

In a possible implementation, after step S1023, the method further comprises: depositing an intrinsic semiconductor layer on the second semiconductor layer, the second semiconductor layer and the intrinsic semiconductor layer together constituting an n-region of the cell unit (SI024).

In the color solar cell provided in the present disclosure, by forming the anti-reflection layer configured to display a color pattern on the cell unit, the color pattern effect of the solar cell is achieved, thereby avoiding the color of the solar cell from being monotonous. It helps beautify the appearance of the solar cell and improve its adaptability. Here, the anti-reflection layer may be light-transparent, so as to ensure that light rays, such as sunlight, penetrate through the anti-reflection layer and enters the cell unit to realize photovoltaic conversion, thereby guaranteeing the power generation efficiency of the cell unit. The color solar cell may not only meet the aesthetic requirements in building integration, but also meet the personalized customization requirements, and can better achieve the effect of exhibition and promotion.

### BRIEF DESCRIPTION OF THE DRAWINGS

To describe the technical solutions in the embodiments of the present disclosure more clearly, the following briefly introduces the accompanying drawings required for describing the embodiments. Apparently, the accompanying drawings in the following description show merely some embodiments of the present disclosure, and a person of ordinary skill in the art may still derive other drawings from these accompanying drawings without creative efforts.
FIGS. 1A-1B show flow charts of a method for preparing a color solar cell according to an embodiment;
FIGS. 2A to 2E show flow charts of a process for preparing a color solar cell according to an embodiment;
FIG. 3 is a schematic view of a color solar cell according to an embodiment;
FIG. 4 is a schematic view of the color solar cell according to an embodiment;
FIG. 5 is a schematic view of the color solar cell according to an embodiment;
FIG. 6A is a cross section view of a color solar cell along a direction according to an embodiment;
FIG. 6B is a cross section view of a color solar cell in another direction according to an embodiment;
FIG. 7 shows a flow chart of a method for preparing a color solar cell according to an embodiment; and
FIGS. 8A to 8F show flow charts of a process for preparing a color solar cell according to an embodiment.

### DETAILED DESCRIPTION

The color solar cell and the preparation method thereof provided in the present disclosure will be described in further detail with reference to the accompanying drawings and the embodiments, to clearly present the objects, technical solutions, and advantages of the present disclosure. It should be understood that the exemplary embodiments described herein are merely illustrations of the present disclosure and are not intended to limit the present disclosure.

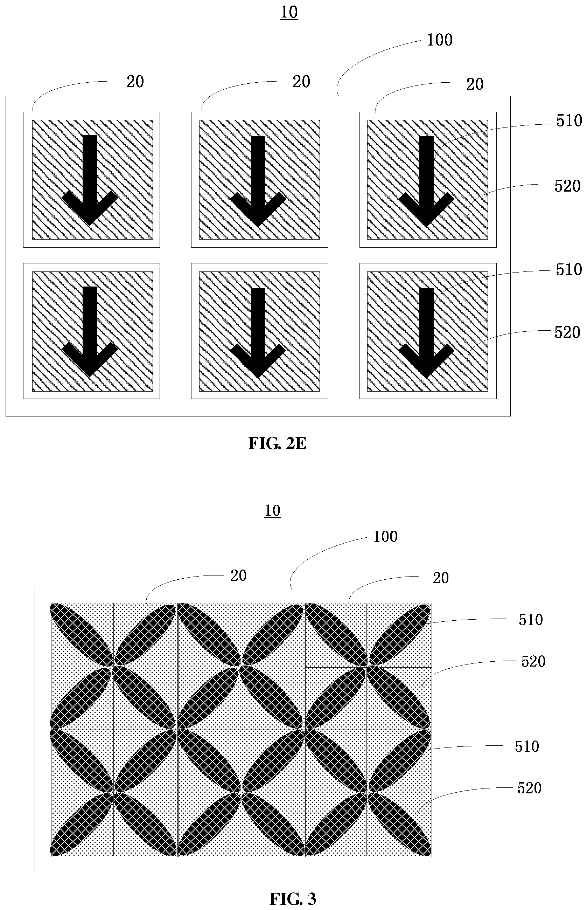

There is provided in the present disclosure a color solar cell 10. As shown in FIG. 2E, the color solar cell 10 includes: a cell unit 20; and an anti-reflection layer 500 disposed on the cell unit 20 and used to display a color pattern.

In the color solar cell 10 provided in the present disclosure, the color pattern effect of the solar cell can be achieved by forming the anti-reflection layer 500, which is used to display a color pattern, on the cell unit 20, thereby avoiding a single color thereof, facilitating to beautify the appearance of the solar cell, and improving its adaptability. Here, the anti-reflection layer 500 may be light-transparent, such that light rays, such as sunlight, may pass through the anti-reflection layer 500 and enter the cell unit 20 to realize photoelectric conversion, thereby ensuring the power generation efficiency of the cell unit 20. The color solar cell not only meet the aesthetic requirements of building integration, but also meet the personalized customization requirements, so that it can better achieve the effect of exhibition and promotion.

It should be understood that the anti-reflection layer 500 may reduce the reflection of incident light, which is advantageous for improving the photoelectric conversion efficiency of the cell unit 20.

In order to obtain the color pattern, in a possible embodiment, the anti-reflection layer 500 includes a plurality of anti-reflection layers and at least two anti-reflection layers present different colors to highlight the color effect.

As mentioned above, the anti-reflection layer 500 includes a plurality of anti-reflection layers, and the number of the anti-reflection layers is not limited. In addition, when a plurality of cell units 20 are provided, whether the anti-reflection layers are located on the same cell unit 20 is not limited either.

In order to obtain the color pattern effect, at least two of the plurality of anti-reflection layers have different thicknesses. For example, there may be provided three anti-reflection layers, i.e., a first anti-reflection layer, a second anti-reflection layer and a third anti-reflection layer. The thicknesses of the three anti-reflection layers may be different from each other. Alternatively, the thicknesses of two of the anti-reflection layers may be the same, but different from the thickness of the third one.

As shown in FIG. 2E, the anti-reflection layer 500 may include: a first anti-reflection layer 510 and a second anti-reflection layer 520. The first anti-reflection layer 510 and the second anti-reflection layer 520 present different colors.

In a possible embodiment, the first anti-reflection layer 510 and the second anti-reflection layer 520 may be laminated (completely laminated or partially laminated) to present an effect of gradual color changing.

In a possible embodiment, the first anti-reflection layer 510 and the second anti-reflection layer 520 may be non-laminated, and the two anti-reflection layers may be disposed at different positions on the same plane, so as to cooperate with each other to form a color pattern.

The first anti-reflection layer 510 and the second anti-reflection layer 520 may be disposed on the same cell unit 20 or may be disposed on different cell units 20. Regarding at least one first anti-reflection layer 501, they may be disposed on the same cell unit 20 at the same time, or may be disposed on a plurality of cell units 20 at the same time. The above solution is applicable to the second anti-reflection layer 502.

In a possible embodiment, the pattern corresponding to the first anti-reflection layer 510 is different from the pattern corresponding to the second anti-reflection layer 520. For example, the above pattern may be an animal, a plant, a traffic sign, a shape of a trademark, a product advertisement design configuration, a two-dimensional code and the like. In addition, the edge of the above patterns may adopt a design which has a stepped shape with a certain gradient and layers.

For example, as shown in FIG. 2E or FIG. 3, a pattern corresponding to the first anti-reflection layer 510 is complementary to a pattern corresponding to the second anti-reflection layer 520, and a sum of an area of the first anti-reflection layer 510 and an area of the second anti-reflection layer 520 is equal to an area of at least one of the cell units 20.

For example, when the anti-reflection layer is disposed on a conductive layer 400 of the cell unit 20, a sum of an area of the first anti-reflection layer 510 and an area of the second anti-reflection layer 520 that are disposed on the same cell unit 20 is equal to an area of the conductive layer 400 of the cell unit 20.

In a possible embodiment, the pattern corresponding to the first anti-reflection layer 510 is the same as the pattern corresponding to the second anti-reflection layer 520.

Furthermore, the anti-reflection layer 500 further includes: a third anti-reflection layer 530. The first anti-reflection layer 510, the second anti-reflection layer 520 and the third anti-reflection layer 530 present different colors. By disposing the third anti-reflection layer 530 described above, the solar cell is provided with more colors, thereby making the color patterns of the solar cell more diverse.

One or a plurality of third anti-reflection layers 530 can be provided. In addition, when a plurality of third anti-reflection layers 530 are provided, at least two of the third anti-reflection layers 530 present different colors. For example, some of the third anti-reflection layers 530 can present the same color and the other of the third anti-reflection layers 530 can present different colors, or all of the third anti-reflection layers 530 can present different colors.

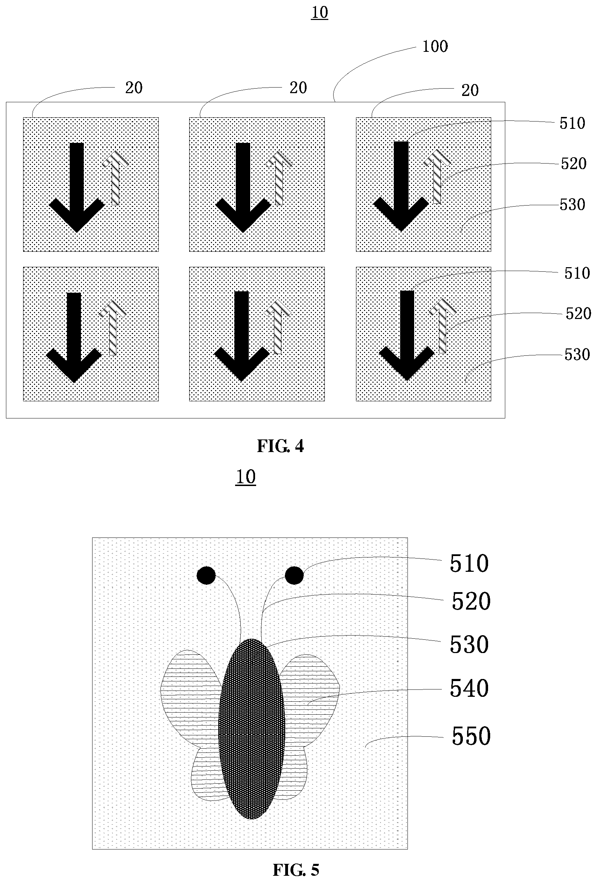

It can be understood that, as shown in FIG. 5, the third anti-reflection layer 530, the fourth anti-reflection layer 540 and the fifth anti-reflection layer 550 therein are all included in the above-mentioned third anti-reflection layer.

In order to impart diversification to the patterns, in a possible embodiment, the patterns corresponding to at least two of the third anti-reflection layers 530 are different.

In a possible embodiment, the pattern corresponding to the first anti-reflection layer 510, the pattern corresponding to the second anti-reflection layer 520, and the pattern corresponding to the third anti-reflection layer 530 may be complementary.

As shown in FIG. 4 or FIG. 5, there may be provided a plurality of cell units 20. A sum of an area of the first anti-reflection layer 510, an area of the second anti-reflection layer 520 and an area of the third anti-reflection layer 530 is equal to an area of the conductive layer 400 on at least one of the cell units 20.

FIG. 4 shows an example in which a sum of an area of the first anti-reflection layer 510, an area of the second anti-reflection layer 520 and an area of the third anti-reflection layer 530 is equal to an area of the conductive layer 400 on one cell unit 20.

FIG. 5 shows an example in which a sum of an area of the first anti-reflection layer 510, an area of the second anti-reflection layer 520 and an area of the third anti-reflection layer 530 is equal to an area of the conductive layer 400 on a plurality of cell units 20.

In a possible embodiment, an anti-reflection layer 500 having a preset thickness may be formed on the cell unit 20, such as the conductive layer 400, to present a certain color.

In a possible embodiment, the color presented by the anti-reflection layer 500 can be changed by changing the thickness of the anti-reflection layer 500. Exemplarily, the thicknesses of the first anti-reflection layer 510, the second anti-reflection layer 520, and the third anti-reflection layer 530 are different.

In a possible embodiment, the color presented by the anti-reflection layer 500 can be changed by changing the material of the anti-reflection layer 500. Exemplarily, the materials of the first anti-reflection layer 510, the second anti-reflection layer 520, and the third anti-reflection layer 530 are different.

For example, the anti-reflection layer 500 is made of SixNy, where a value range of x:y is 0.75∼4:1, such as 0.75:1, 0.8:1, 0.9:1, 1:1, 1.1:1, 1.3:1, 1.5:1, 1.7:1, 1.9:1, 2.1:1, 2.5:1, 2.7:1, 2.9:1, 3.1:1, 3.6:1, 3.8:1, 4:1, and etc.

When the anti-reflection layer 500 is made of the same material, the color presented by the anti-reflection layer 500 can be changed by simply changing the thickness of the anti-reflection layer 500.

When the anti-reflection layer 500 has the same thickness, the color presented by the anti-reflection layer 500 may also be changed by changing its material. For example, the anti-reflection layer 500 maybe made of silicon nitride, silicon dioxide, silicon oxide, aluminium oxide, titanium dioxide, zinc sulfide, or the like. It can be understood that the above-mentioned anti-reflection layer 500 can be formed on the cell unit 20 with a method applicable to the solar cell, and it can be ensured that the normal performance of the solar cell is not affected during the forming process.

Furthermore, when the thickness and the material of the anti-reflection layer 500 are changed simultaneously, the color presented by the anti-reflection layer 500 can also be changed. Taking a CIGS thin film solar cell as an example, a Mo layer having a thickness of 800 nm is prepared as a back electrode on a soda-lime glass having a thickness of 3 mm through a vacuum sputtering method. A CIGS layer is formed on a molybdenum electrode through a three-step co-evaporation method, and the CIGS layer is used as an absorption layer, where a thickness of the CIGS layer is 1.5 µm. A CdS layer is deposited on the CIGS layer through a chemical bath deposition (CBD) method, and the CdS layer is used as a buffer layer, where a thickness of the CdS layer is 50 nm. An i-ZnO layer is formed on the CdS layer through a sputtering process, and the i-ZnO layer is used as an intrinsic layer, where a thickness of the i-ZnO layer is 50 nm. An AZO layer is deposited on the i-ZnO layer through a sputtering method, and the AZO layer is used as a transparent conductive layer, where a thickness of the AZO layer is 1000 nm. Through the sputtering process and under the same nitrogen/argon partial pressure and same transmission speed, a cell of corresponding color can be obtained by fixing the sputtering power and changing the total gas flow and by fixing the total gas flow and changing the sputtering power. Here, the target material is a silicon target having a purity of 99.95%. The purity of the nitrogen and argon used here is 99.99%, the transmission speed is 220 cm/min, the temperature of the substrate is 45°C and the vacuum degree maintains at 1*10-4Pa. The specific parameters are as follows.
① When the nitrogen/argon partial pressure is 0.52, the total gas flow is 950 mL/min, the sputtering power is 70 kW, the thickness of the silicon nitride thin film is 100 nm, and the ratio of silicon to nitrogen is 1.1:1.0, the formed silicon nitride anti-reflection layer presents a green color.
② When the nitrogen/argon partial pressure is 0.52, the total gas flow is 950 mL/min, the sputtering power is 110 kW, the thickness of the silicon nitride thin film is 200 nm, and the ratio of silicon to nitrogen is 1.9:1.0, the formed silicon nitride anti-reflection layer presents a yellow color.
③ When the nitrogen/argon partial pressure is 0.52, the total gas flow is 950 mL/min, the sputtering power is 150 kW, the thickness of the corresponding silicon nitride thin film is 300 nm, and the ratio of silicon to nitrogen is 3.6:1.0, the formed silicon nitride anti-reflection layer presents a red color.

Additionally, a continuously varying intermediate color may be obtained by adjusting the thickness and the ratio of silicon to nitrogen in the silicon nitride thin film.

Exemplarily, the anti-reflection layer 500 includes a plurality of anti-reflection layers, and the Si:N ratios of at least two of the plurality of anti-reflection layers are different. As can be seen from the above, the anti-reflection layer 500 may be made of silicon nitride. When the Si:N ratios in the silicon nitride are different, the anti-reflection layer 500 may present different colors.

In a possible embodiment, the cell unit 20 includes: a substrate 100 and a function layer disposed on the substrate 100. Here, the anti-reflection layer 500 is disposed on the substrate 100.

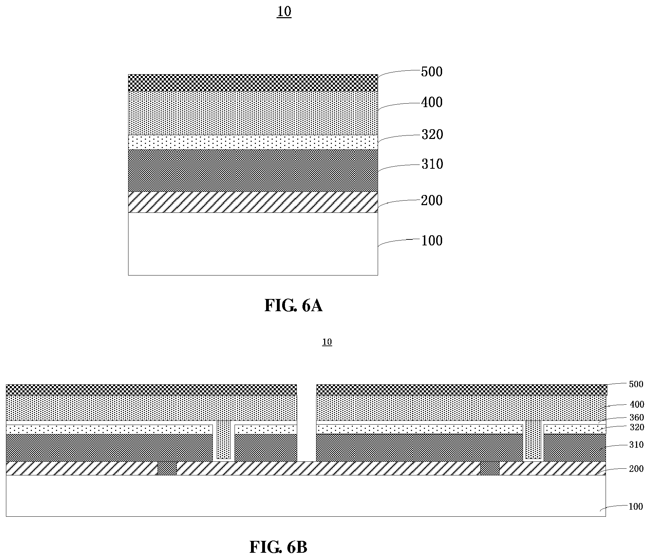

Referring to FIG. 6A and FIG. 6B, cross section views of a color solar cell 10 in two directions are provided. In combination with the cross section views of the color solar cell 10 in FIG. 6A and FIG. 6B, as further shown in FIG. 6A and FIG. 6B, the function layer includes:
a back electrode layer 200 disposed on the substrate 100;
a semiconductor layer 300 disposed on the back electrode layer 200;
a conductive layer 400 disposed on the semiconductor layer 300; and
a connection part 350 penetrating through the semiconductor layer 300, one end of the connection part 350 being electrically connected with the back electrode layer 200 and the other end of the connection part 350 being electrically connected with the conductive layer 400.

Here, the anti-reflection layer 500 is disposed on the conductive layer 400.

In a possible embodiment, the cell unit 20 includes: a substrate 100 on which an anti-reflection layer 500 is disposed, and a function layer is disposed on the anti-reflection layer 500.

Furthermore, the function layer includes:
a back electrode layer 200 disposed on the anti-reflection layer 500 on the substrate 100;
a semiconductor layer 300 disposed on the back electrode layer 200;
a conductive layer 400 disposed on the semiconductor layer 300; and
a connection part 350 penetrating through the semiconductor layer 300, one end of the connection part 350 being electrically connected with the back electrode layer 200 and the other end of the connection part 350 being electrically connected with the conductive layer 400.

In the case where the anti-reflection layer 500 is disposed on the substrate 100, the anti-reflection layer 500 may be disposed on the front side or the reverse side of the substrate 100, or may be disposed on the front side and the reverse side of the substrate 100 at the same time.

In an embodiment, the substrate 100, the light-transparent anti-reflection layer 500, the function layer and the light-transparent anti-reflection layer 500 are sequentially laminated, which is not only limited to the descriptions mentioned above.

In another embodiment, the light-transparent anti-reflection layer 500, the substrate 100, the function layer and the light-transparent anti-reflection layer 500 are sequentially laminated.

In yet another embodiment, the light-transparent anti-reflection layer 500, the substrate 100, the light-transparent anti-reflection layer 500 and the function layer are sequentially laminated.

In still yet another embodiment, the light-transparent anti-reflection layer 500, the substrate 100, the light-transparent anti-reflection layer 500, the function layer and the light-transparent anti-reflection layer 500 are sequentially laminated.

The semiconductor layer 300 may be a semiconductor material capable of achieving good photoelectric conversion (i.e., PV conversion). For example, CIGS thin film cell is a shorthand for solar thin film cell CuInxGa(1-x)Se2. CIGS mainly consists of Cu, In, Ga and Se, and has the advantages of high light absorption ability and high conversion efficiency, good power generation stability, long power generation time during the daytime, large power generation amount, low production cost, short energy recovery period, and the like.

In a possible embodiment, the semiconductor layer 300 includes:
a first semiconductor layer 310 disposed on the back electrode layer 200; and
a second semiconductor layer 320 which is disposed on the first semiconductor layer 310 and is in p-n bonding with the first semiconductor layer 310.

It can be understood that one of the first semiconductor layer 310 and the second semiconductor layer 320 is an n-type semiconductor layer, and the other one is a p-type semiconductor layer. Moreover, p-n bonding can be performed between the first semiconductor layer 310 and the second semiconductor layer 320. Either the first semiconductor layer 310 or the second semiconductor layer 320 can be set to be an n-type semiconductor layer. It is not limited to the direct bonding of the first semiconductor layer 310 can the second semiconductor layer 320, other semiconductor layers having the same conductive type as the first semiconductor layer 310 can also be disposed between the first semiconductor layer 310 and the second semiconductor layer 320. Alternatively, other semiconductor layers having the same conductive type as the second semiconductor layer 320 can also be disposed between the first semiconductor layer 310 and the second semiconductor layer 320.

For example, the material of the first semiconductor layer 310 is a p-type semiconductor, and a p-region is formed in the cell unit 20. The material of the second semiconductor layer 320 is an n-type semiconductor, and an n-region is formed in the cell unit 20.

In a possible embodiment, the connection part 350, when penetrating through the semiconductor layer 300, is in contact with or connected with the first semiconductor layer 310 and the second semiconductor layer 320 respectively. The stability of the structure of the connection part 350 can be achieved by taking the first semiconductor layer 310 and the second semiconductor layer 320 as a support.

In a possible embodiment, an intrinsic semiconductor layer 360 is further disposed between the second semiconductor layer 320 and the conductive layer 400. The second semiconductor layer 320 and the intrinsic semiconductor layer 360 together constitute an n-region in the cell unit 20.

In a possible embodiment, a plurality of cell units 20 are provided and the plurality of cell units 20 are connected in series.

In a possible embodiment, the anti-reflection layer 500 is disposed on the conductive layer 400. The color solar cell unit 10 further includes: electrodes disposed on the anti-reflection layer 500 and configured to conduct out charges generated by the cell unit 20s. Here, the electrodes may be coplanar with the anti-reflection layer 500, and the electrodes may be linear electrodes. Exemplarily, the linear electrodes are coplanar with the anti-reflection layer 500. The linear electrodes are disposed between the pluralities of anti-reflection layers in a spaced manner and are connected with the conductive layer 400, so as to conduct out charges generated by the cell unit 20s.

Exemplarily, there may be a certain interval between the first anti-reflection layer and the second anti-reflection layer, and a linear electrode is provided at the interval.

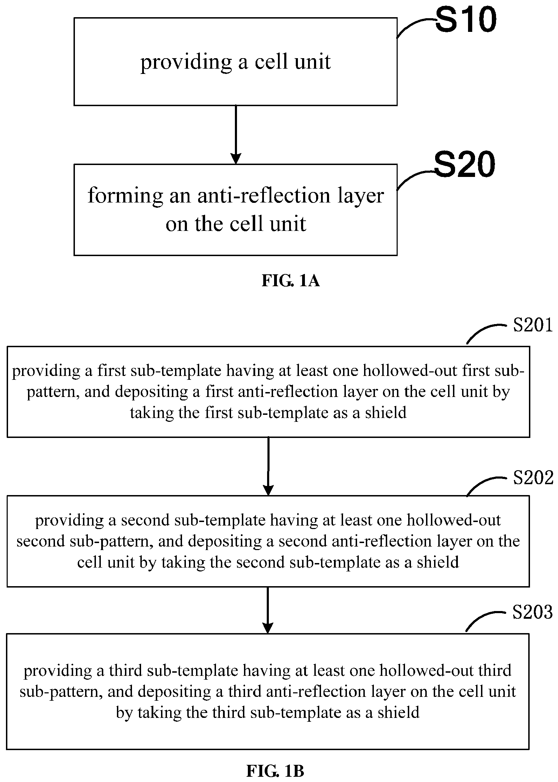

In another aspect, there is further provided in the present disclosure a method for preparing a color solar cell 10. Referring to FIG. 1A, a flowchart of a method for preparing a color solar cell 10 is provided in the present disclosure.

A method for preparing a color solar cell 10 includes the following steps.

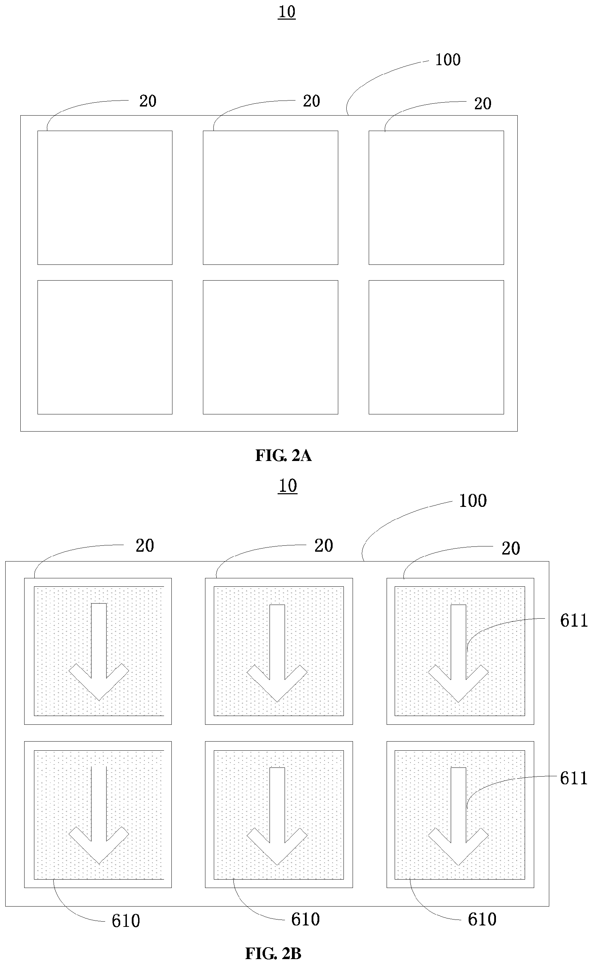

In step S10, as shown in FIG. 2A, a cell unit 20 is provided; and

In step S20, an anti-reflection layer is formed on the cell unit 20, where the anti-reflection layer is configured to display a color pattern.

Herein, the step S20 may be implemented by providing a template having at least one hollowed-out pattern, and depositing, with the template as a shield, an anti-reflection layer 500 on at least one cell unit 20, such as on the conductive layer 400.

For example, a flowchart of the step S20 is shown in FIG. 1B. As shown in FIG. 2B, the step S20 further includes the following steps.

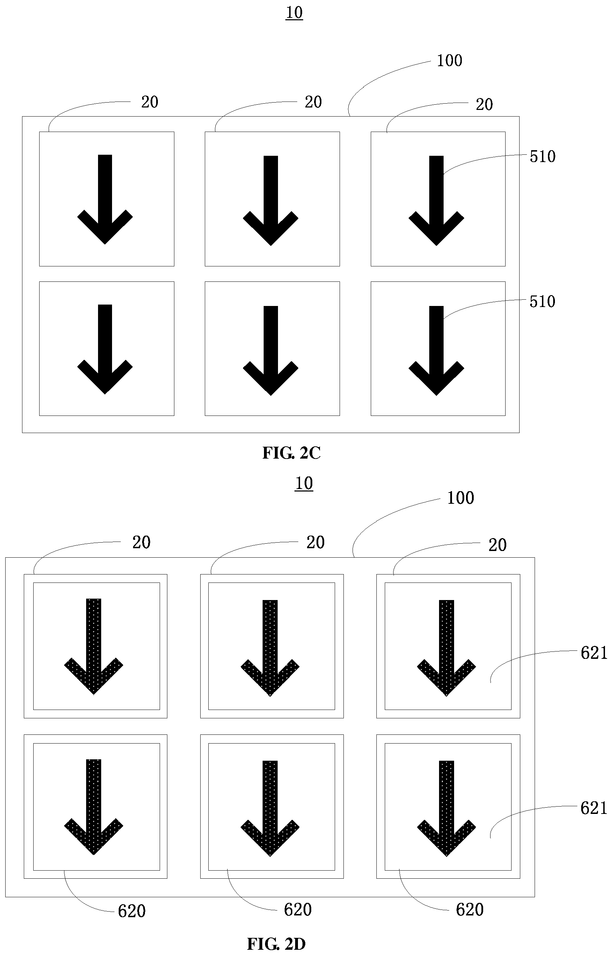

In step S201, a first sub-template 610 having at least one hollowed-out first sub-pattern 611 is provided, and an light-transparent first anti-reflection layer 510 is deposited on at least one cell unit 20, such as on the conductive layer 400, with the first sub-template 610 as a shield (please refer to FIG. 2C).

In step S202, as shown in FIG. 2D, a second sub-template 620 having at least one hollowed-out second sub-pattern 621 is provided, and an light-transparent second anti-reflection layer 520 is deposited on at least one cell unit 20, such as on the conductive layer 400, with the second sub-template 620 as a shield (please refer to FIG. 2E). Here, the first anti-reflection layer 510 and the second anti-reflection layer 520 present different colors.

With the method for preparing the color solar cell provided in the present embodiment, the first anti-reflection layer 510 and the second anti-reflection layer 520 that have different colors are formed on the cell unit 20, such as on the conductive layer 400, so as to achieve the color pattern effect of the solar cell, avoid the color of the solar cell from being monotonous, facilitate to beautify the appearance of the solar cell and improve its adaptability.

Each step involved in the above preparation method will be described hereinafter.

In step S10, a substrate 100 may be provided, and at least one cell unit 20 may be formed on the surface of the substrate 100. Here, the substrate 100 involved may be monocrystalline silicon, polycrystalline silicon, amorphous silicon, glass or soda-lime glass. The selection of the substrate 100 may be continuously updated with the development of science and technology.

The cell unit 20 is a working unit that converts solar energy into electric energy. It can be understood that there is a layer of conductive material that may conduct electricity on the surface of the cell unit 20 and the layer of conductive material forms the conductive layer 400. The conductive layer 400 is light-transparent. For example, the conductive layer 400 may be transparent conductive oxide (TCO), such as ZnO: Al.

In step S201, the first sub-template 610 is arranged for forming the first anti-reflection layer 510 through the first sub-pattern 611 thereon. The size, pattern, shape and thickness of the first sub-template 610 are not exemplarily limited. The first sub-pattern 611 on the first sub-template 610 is not exemplarily limited. For example, the first sub-pattern 611 may be an animal, a plant, a traffic sign, a shape of a trademark, a product advertisement design configuration or a two-dimensional code. The edge of the hollowed-out first sub-pattern 611 on the first sub-template 610 may adopt a design which has a stepped shape with a certain gradient and layers.

In step S202, a second sub-template 620 having at least one hollowed-out second sub-pattern 621 is provided, and a light-transparent second anti-reflection layer 520 is deposited on the conductive layer 400 on at least one cell unit 20 with the second sub-template 620 as a shield. Here, the first anti-reflection layer 510 and the second anti-reflection layer 520 present different colors.

The size, pattern, shape and thickness of the second sub-template 620 are not exemplarily limited. The second sub-pattern 621 on the second sub-template 620 is not exemplarily limited either. For example, the second sub-pattern 621 may be an animal, a plant, a traffic sign, a shape of a trademark, a product advertisement design configuration or a two-dimensional code. The edge of the hollowed-out second sub-pattern 621 on the second sub-template 620 may adopt a design which has a stepped shape with a certain gradient and layers.

As for the at least one first sub-pattern 611 on the first sub-template 610 and the at least one second sub-pattern 621 on the second sub-template 620, all of the plurality of the first sub-patterns 611 (the plurality of the second sub-patterns 621) may be the same, or some of them may be the same, or all of them may be different.

The first sub-template 610 and the second sub-template 620 cooperate with each other to form the first anti-reflection layer 510 and the second anti-reflection layer 520 that have different colors on the conductive layer 400.

In a possible embodiment, the anti-reflection layer is formed through a chemical vapor deposition (CVD) process, and the thickness of the anti-reflection layer 500 is controlled by controlling the deposition rate or the deposition time.

Different anti-reflection layers 500 may have different thicknesses through different deposition time, different deposition rates, or different materials or ratios adopted in the anti-reflection layers during deposition, so that the anti-reflection layers 500 with different thicknesses may present different colors.

The sizes of the first sub-template 610 and the second sub-template 620 may be customized according to requirements. The first sub-template 610 and the second sub-template 620 may be made on part of the solar cell, or may extend to the entire solar cell. The hollowed-out patterns of the first sub-template 610 and the second sub-template 620 are within the templates.

The materials of the first sub-template 610 and the second sub-template 620 may be quartz, graphite, or other materials for shielding. When the anti-reflection layer is formed in the hollowed-out pattern, the anti-reflection layer may be formed through a deposition method, such as a Plasma Enhanced Chemical Vapor Deposition (PECVD) method. Here, the first sub-template 610 and the second sub-template 620 also meet the requirements of the PECVD procedure.

The first sub-template 610 and the second sub-template 620 may be attached onto the conductive layer 400 during the process, and may also be fixed to ensure that the first sub-template 610 and the second sub-template 620 are relative rest, to avoid movement during the process. After the process is completed, the templates are removed. That is, the first anti-reflection layer and the second anti-reflection layer are formed on the conductive layer 400. Thus, the preparation of the thin film solar cell with color patterns is completed. Here, the template may be fixed on the solar cell through a clipping piece, a clamping piece and the like, to ensure that the conductive layer 400 is not damaged during the fixing process.

In the present embodiment, after the conductive layer 400 is sputtered in the process of producing the thin film cell, the first sub-template 610 is adopted to cover the conductive layer 400. The conductive layer 400 may be a layer doped with zinc oxide, i.e., a TCO layer. The first anti-reflection layer 510 is formed in the region of the hollowed-out first sub-pattern 611 (For example, the first anti-reflection layer is formed through deposition). Then, the second sub-template 620 is adopted to cover the conductive layer 400, and the second anti-reflection layer 520 is formed in the region of the hollowed-out second sub-pattern 621 (For example, the second anti-reflection layer is formed through deposition).

The first sub-template 610 and the second sub-template 620 cooperate with each such that the first anti-reflection layer 510 and the second anti-reflection layer 520 deposited on the conductive layer 400 present different colors (In an embodiment, the corresponding first anti-reflection layer and second anti-reflection layer have different thicknesses). The first anti-reflection layer 510 and the second anti-reflection layer 520 of different thicknesses have different colors, thereby realizing he color pattern effect on the surface of the thin film solar cell.

It can be known from above that the preparation method for the color solar cell 10 is simple in process steps, convenient to operate, and high in repeatability and reliability, and may be used in large-scale industrial production as well as customized production. The color solar cell prepared with this method not only meets the aesthetic requirements in building integration, but also meets the personalized customization requirements, and can better achieve the effect of exhibition and promotion.

In a possible embodiment, the first anti-reflection layer 510 and the second anti-reflection layer 520 may be laid on the conductive layer 400 of the color solar cell 10 in a spaced manner. An electrode, such as a linear electrode, may be arranged in the space to conduct out charges generated by the cell unit 20, so that the conversion efficiency of the color solar cell 10 is improved.

In a possible embodiment, the second sub-pattern 621 may be different from the first sub-pattern 611. For example, as shown in FIG. 2E, the second sub-pattern 621 is complementary to the first sub-pattern 611, and the sum of the area of the second pattern 622 and the area of the first pattern 611 is equal to the area of the conductive layer 400. With such an arrangement, a color pattern may cover the cell unit 20, and the color pattern has different color shades to highlight the display effect of the pattern.

In a possible embodiment, the second sub-pattern 621 may be the same as the first sub-pattern 611.

The material of the first sub-template 610, the second sub-template 620 or more templates may be quartz, graphite or other materials that may realize the effect of shielding. The hollowed-out pattern in the first sub-template 610, the second sub-template 620 or more templates may be arbitrary. The first sub-template 610, the second sub-template 620 or more templates need to be fixed and be in contact with the conductive layer 400. In a possible embodiment, the color of the anti-reflection layer 500 is determined based on different thicknesses of a deposited silicon nitride thin film. The anti-reflection layer 500 may be deposited once or in multiple times. The customized pattern color may be obtained by replacing different templates.

Referring to FIGS. 2A-2E, a flow chart of a preparation process for the color solar cell 10 is provided. As shown in FIG. 2A, the spaced cell units 20 are prepared on the substrate 100, and the cell units 20 are connected in series. In FIG. 2B, the first sub-template 610 covers the cell unit 20. The hollowed-out portion in FIG. 2B is the first sub-pattern 611. The anti-reflection layer 500 is deposited on the surface of the conductive layer 400 for the first time by taking the first sub-template 610 as a shield. FIG. 2C shows a view after the first deposition is completed. Here, the anti-reflection layer 500 is deposited on the hollowed-out first sub-pattern 611 to form the first anti-reflection layer 510. As shown in FIG. 2D, the second sub-template 620 covers the cell unit 20. The anti-reflection layer 500 is deposited on the surface of the conductive layer 400 for the second time by taking the second sub-template 620 as a shield. A hollowed-out second sub-pattern 621 is formed on the second sub-template 620. The size of the first sub-template 610 may be may be equal to the size of the second sub-template 620. The first sub-pattern 611 and the second sub-pattern 621 are complementary to each other. FIG. 2E shows a view after the second deposition of the anti-reflection layer 500 is completed. Here, the anti-reflection layer 500 is deposited on the hollowed-out second sub-pattern 621 to form the second anti-reflection layer 520. The first sub-template 610 and the second sub-template 620 shown in FIGS. 2A-2E have the same size.

In the present embodiment, the area of the second sub-template 620 may be greater than the area of the first sub-template 610 as long as the deposition of the two patterns may be realized. In addition, the area of the first sub-template 610 may be equal to the area of one cell unit 20, or may be equal to the sum of the areas of several cell units 20. Exemplarily, the area of the first sub-template 610 may be determined based on actual needs. In FIG. 2, the area of the first sub-template 610 is slightly smaller than the area of one cell unit 20 in order to clearly describe the preparation process of the color solar cell 10.

Referring to FIGS. 3-5, schematic diagrams of the color solar cell 10 are provided. In FIG. 3, the first anti-reflection layer 510 and the second anti-reflection layer 520 are formed on the surface of each cell unit 20. The first anti-reflection layer 510 and the second anti-reflection layer 520 have different thicknesses, and thus the colors displayed are different. Every four cell units 20 form patterns in one style.

In a possible embodiment, after step S202, the method further includes: step S203, in which at least one third sub-template having at least one hollowed-out third sub-pattern is provided, and at least one light-transparent third anti-reflection layer 530 is formed on the conductive layer 400 of at least one of the cell units 20 by taking the third sub-template 630 as a shield. Here, at least one of the first anti-reflection layer 510 and the second anti-reflection layer 520 presents a color that is different from the color presented by the third anti-reflection layer 530.

By arranging the third anti-reflection layer 530, the solar cell may be provided with more colors, thereby diversifying the color patterns. Here, the color presented by the third anti-reflection layer 530 may be different from the color presented by one or both of the first anti-reflection layer 510 and the second anti-reflection layer 520.

One or a plurality of third anti-reflection layers 530 may be provided. Moreover, when a plurality of the third anti-reflection layers 530 are provided, at least two of the third anti-reflection layers 530 present different colors. For example, some of the third anti-reflection layers 530 may present the same color and some of the third anti-reflection layers 530 may present different colors, or all of the third anti-reflection layers 530 may present different colors.

It is to be understood that one or a plurality of (such as, 2, 3, 4, 5 or more) the third sub-templates 630 may be provided. Moreover, when a plurality of the third sub-templates 630 are provided, the third sub-patterns 631 on at least two of the sub-templates 630 are different.

For example, as shown in FIG. 5E, there may be provided three third sub-templates 630 and the third sub-patterns 631 on the three third sub-templates 630 are different from each other. Moreover, the third anti-reflection layers 530 of three colors may be formed. As shown in FIG. 5, the three third sub-templates 630 may be understood to be the third sub-template, a fourth template and a fifth template, respectively, and the formed three third anti-reflection layers 530 of three colors may be understood to be the third anti-reflection layer 530, a fourth anti-reflection layer 540 and a fourth anti-reflection layer 550.

In a possible embodiment, the first sub-pattern 611, the second sub-pattern 621 and the third sub-pattern 631 are complementary to each other. In a possible embodiment, the sum of the area of the first sub-pattern 611, the area of the second sub-pattern 621 and the area of the third sub-pattern 631 is equal to the area of the conductive layer 400 on at least one of the cell units 20. The conductive layer 400 involved herein may be understood to be the conductive layer 400 on the same cell unit 20, and may also be understood to be the conductive layer 400 on all of the cell units 400.

Based on the above, the non-hollowed-out portion of the first sub-template 610 may be made to be complementary to the sum of the area of the second sub-pattern 621 and the area of the third sub-pattern 631. The third anti-reflection layer 530 is formed on the conductive layer 400 of at least one of the cell units 20 by taking the third sub-template 630 as a shield (For example, the anti-reflection layer may be formed through a chemical vapor deposition CVD process). The first anti-reflection layer 510, the second anti-reflection layer 520 and the third anti-reflection layer 530 may have different thicknesses. Moreover, the thickness of the anti-reflection layer 500 may be changed by controlling the deposition rate or the deposition period of time.

In FIG. 4, the first anti-reflection layer 510, the second anti-reflection layer 520 and the third anti-reflection layer 530 are formed on the surface of each cell unit 20. Each cell unit 20 forms a pattern of one style. In FIG. 4, the color of the first anti-reflection layer 510, the color of the second anti-reflection layer 520 and the color of the third anti-reflection layer 530 are different from each other (i.e., the thicknesses of the anti-reflection layers are different). The pattern of this style can be used as a traffic sign of "GIVE WAY TO ONCOMING VEHICLES". The thickness of the first anti-reflection layer 510 and the thickness of the second anti-reflection layer 520 may be the same, but are different from the thickness of the third anti-reflection layer 530.

In FIG. 5, the first anti-reflection layer 510, the second anti-reflection layer 520, the third anti-reflection layer 530, the fourth anti-reflection layer 540 and the fifth anti-reflection layer 550 (the third anti-reflection layer 530, the fourth anti-reflection layer 540 and the fifth anti-reflection layer 550 may also be deemed as three different kinds of third anti-reflection layers) are formed on the surface of one cell unit 20. Each cell unit 20 forms a pattern of one style. In FIG. 5, a plurality of cell units 20 may be arranged to form the pattern shown therein. The thicknesses of the first anti-reflection layer 510, the second anti-reflection layer 520, the third anti-reflection layer 530, the fourth anti-reflection layer 540 and the fifth anti-reflection layer 550 in FIG. 5 are different from each other. The pattern shown in FIG. 5 may be used as a plant specimen displaying different colors. The cell unit 20 may also be set to blink at a certain frequency to improve the display function of the pattern. For example, blinking glass may be added on the anti-reflection layer to achieve the blinking function of the anti-reflection layer.

In a possible embodiment, the thicknesses of at least two of the first anti-reflection layer 510, the second anti-reflection layer 520, the third anti-reflection layer 530, the fourth anti-reflection layer 540 and the fifth anti-reflection layer 550 are different or the same, so as to form color patterns.

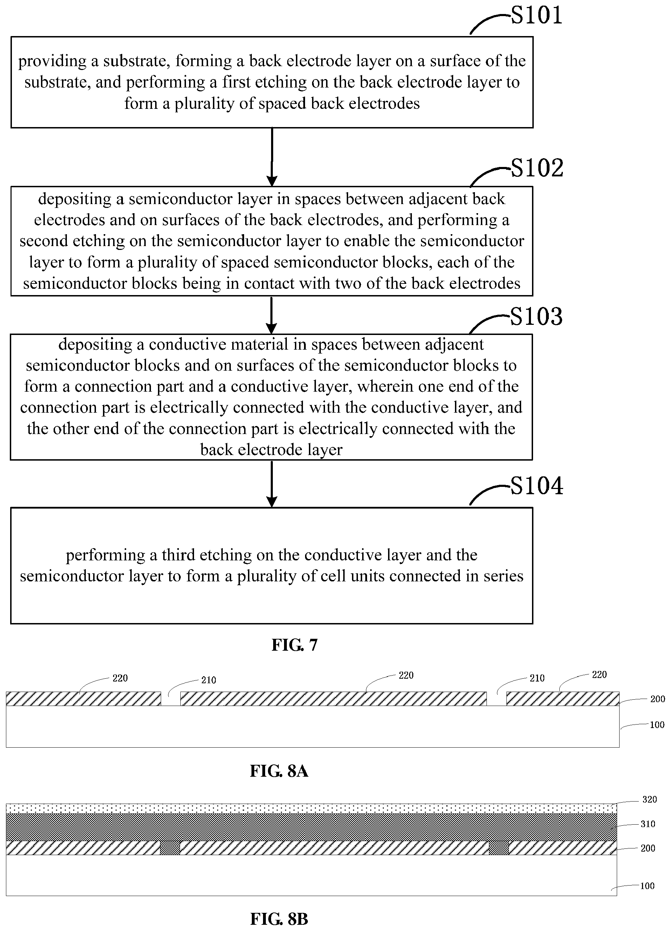

FIG. 7 shows the preparation method for a color solar cell 10. The flowcharts of the preparation processes in FIGS. 8A-8F show the preparation procedure of the color solar cell 10 from multiple aspects.

Please refer to FIG. 8A, in step S101, a back electrode layer 20 is formed on the surface of the substrate 100 (For example, a layer of Mo is deposited as the back electrode layer 200), and a first etching is performed on the back electrode layer 20. After the first etching, the back electrode layer 20 forms a plurality of spaced back electrodes 220. A space between every two adjacent back electrodes 220 is a first groove 210.

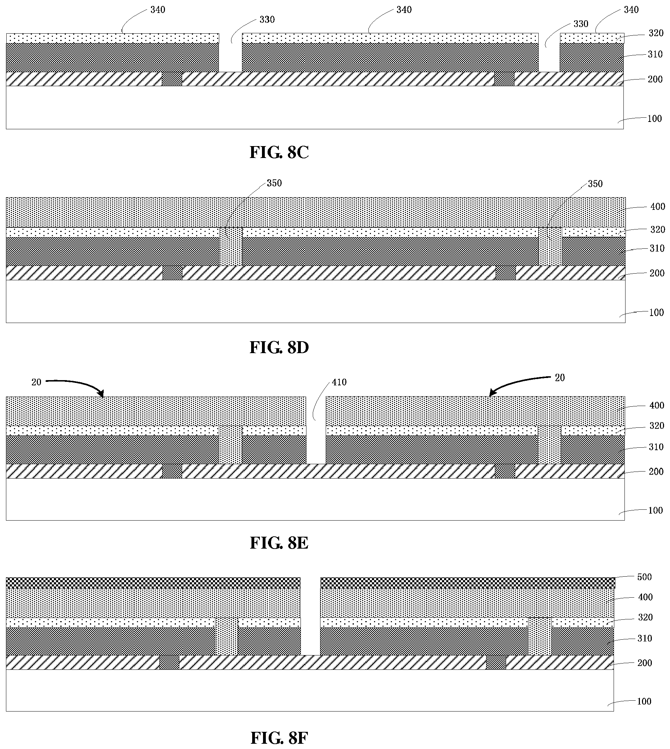

Please refer to FIG. 8B and FIG. 8C, in step S102, a semiconductor layer 300 is formed, such as deposited, in spaces (i.e., the first grooves) between adjacent back electrodes and on surfaces of the back electrodes, and a second etching is performed on the semiconductor layer 30 such that the semiconductor layer 300 forms a plurality of spaced semiconductor blocks 340. A space between every two adjacent semiconductor blocks 340 is a second groove 330. Each second groove 330 is located between adjacent two first grooves 210.

In step S103, a conductive material is deposited in spaces between adjacent semiconductor blocks 340 and on the surfaces of the semiconductor blocks 340 to form a connection part 350 and a conductive layer 400. One end of the connection part 350 is electrically connected with the conductive layer 400, and the other end of the connection part 350 is electrically connected with the back electrode layer 200.

In step S104, a third etching is performed on the conductive layer 400 and the semiconductor layer 300 to form a plurality of cell units connected in series.

In an embodiment, step S102 further includes the following steps.

In step S1021, a first semiconductor layer 310 is formed, such as deposited, in spaces between the adjacent back electrodes 220 and on the surfaces of the back electrodes 220.

In step S1022, a second semiconductor layer 320 that is in p-n bonding with the first semiconductor layer 310 is formed, such as deposited, on the surface of the first semiconductor layer 310.

In step S1023, the second etching is performed on the first semiconductor layer 310 and the second semiconductor layer 320 to form a plurality of the spaced semiconductor blocks 340. Each of the semiconductor blocks 340 is in contact with two of the back electrodes 220.

In an embodiment, the material of the first semiconductor layer 310 is a p-type semiconductor. A p-region is formed in the cell unit 20. The material of the second semiconductor layer 320 is an n-type semiconductor. An n-region is formed in the cell unit 20.

The second semiconductor layer 320 may be deposited on the first semiconductor layer 310 through a chemical bath thin film deposition process. The first semiconductor layer 310 may be made of copper indium gallium selenide. The copper indium gallium selenide layer is plated with a layer of cadmium sulphide (CdS) as a buffer layer. The buffer layer CdS is also called as the second semiconductor layer 320. The first semiconductor layer 310, i.e., the copper indium gallium selenide layer, serves as the p-region. The second semiconductor layer 320, i.e., the buffer layer CdS, severs as the n-region. In the present embodiment, the chemical bath film deposition process may be replaced with a vacuum evaporation method, a sputtering method, a near space sublimation method, an electrodeposition method, and the like.

In an embodiment, an i-type semiconductor layer may be arranged between the first semiconductor layer 310 and the second semiconductor layer 320 such that the semiconductor layers 300 may form a pin contact. Exemplarily, after step S1023, the method further includes the following step.

In step S1024, an intrinsic semiconductor layer 360 is deposited on the second semiconductor layer 320. The intrinsic semiconductor may be intrinsic zinc oxide. The second semiconductor layer 320 and the intrinsic semiconductor layer 360 together constitute the n-region in the cell unit 20.

In an embodiment, a high-sheet-resistance intrinsic semiconductor layer 360, namely the intrinsic zinc oxide layer, may be deposited on the surface of the second semiconductor layer 320 as a first window layer which may be an i-ZnO layer. The first window layer is in a high resistance state. The first window layer and the buffer layer CdS together constitute the n-region.

In this embodiment, after the second etching, the deposited high-sheet-resistance intrinsic semiconductor layer 360, namely the intrinsic zinc oxide layer, is further deposited. The second etching is performed on the semiconductor layer 300 that includes the first semiconductor layer 310 and the second semiconductor layer 320. After the second etching is completed, the intrinsic semiconductor layer 360 and the conductive layer 400 are sputtered through a sputtering deposition method. The intrinsic semiconductor layer 360 may serve as the first window layer, and may be the high-sheet-resistance intrinsic zinc oxide layer. The conductive layer 400 may serve as a second window layer, and may be made of TCO, i.e., ZnO:Al. The conductive layer 400 is in a low resistance state and has high permeability. The conductive layer 400 may output current.

Please refer to FIG. 8D, in step S103, a conductive material is deposited in spaces between the adjacent semiconductor blocks 340 and on the surfaces of the semiconductor blocks 340 to form the connection part 350 and the conductive layer 400. The conductive layer 400 may be formed on the surface of the semiconductor blocks 340 by depositing the conductive material. The second groove 330 may be filled with the conductive material by depositing the second conductive material to form the connection part 350. One end of the connection part 350 is electrically connected to the conductive layer 400, and the other end of the connection part 350 is electrically connected to the back electrode layer 200. The connection part 350 is configured to electrically connect the conductive layer 400 with the back electrode layer 200.

Please refer to FIG. 8E, in step S104, a third etching is performed on the conductive layer 400 and the semiconductor layer 300 (i.e., the first semi-semiconductor layer 310 and the second semi- semiconductor layer 320) to form a plurality of cell units 20 connected in series.

Exemplarily, a third etching is performed on the conductive layer 400 and the semiconductor layer 300. After the third etching, a plurality of third grooves 410 are formed. There are one first groove 210 and one second groove 330 between every two adjacent third grooves 410. Through the third grooves 410, a plurality of cell units 20 connected in series are formed on the surface of the substrate 100. Here, the connection part 350 electrically connects the conductive layer 400 with the back electrode 200 such that the plurality of cell units are connected in series.

The third etching is performed on the first semiconductor layer (for example CIGS) 310, the second semiconductor layer 320 and the conductive layer 400 on the glass substrate. After the third etching, the cell units 20 are connected in series.

Please refer to FIG. 8F, the anti-reflection layer 500 is deposited on the conductive layers 400 of the plurality of cell units 20 connected in series. The deposition procedure may be as follow: the plurality of cell units 20 connected in series prepared on the substrate 100 are placed in a graphite carrier. A customized graphite template is placed above the cell units 20 and is fixed. The whole is placed in plate-type PECVD equipment and is preheated to deposit the anti-reflection layer 500 through a chemical vapor deposition (CVD) process. The anti-reflection layer 500 may be a silicon nitride film. After the deposition is completed, cooling and the like are performed. Then, the graphite template is removed to obtain the color solar cell 10. In order to make the performance of the color solar cell 10 better, some other processes may be performed.

In the present embodiment, the anti-reflection layer 500 (the silicon nitride layer) may be deposited through the PECVD method. It may be understood that the anti-reflection layer 500 may be deposited through a Physical Vapor Deposition (PVD) method and a Chemical Vapor Deposition (CVD) method. The PVD method includes vacuum evaporation, a vacuum sputtering and ton plating. The CVD method includes High Temperature Chemical Vapor Deposition (HTCVD), Plasma Enhanced Chemical Vapor Deposition (PECVD) and Plasma Chemical Vapor Deposition (PCVD). Both the PVD method and the CVD method may be used to deposit the anti-reflection layer 500. The PECVD method is the most commonly used, and the vacuum sputtering method may also be used.

In this embodiment, the above preparation method for the color solar cell 10 may be completed once. The preparation method is simple and may be used to produce patterns of different colors. The preparation method for the color solar cell 10 may also be completed in multiple times to obtain a complex and colorful pattern. With the preparation method for the color solar cell 10, the solar cell with different colors and patterns may be produced using different templates and silicon nitride thin films with different thicknesses or different silicon-nitride ratios as the anti-reflection layer 50.

The technical features in the above embodiments may be combined arbitrarily. For the purpose of conciseness of description, not all of the possible combinations of the technical features in the above embodiments are described. However, these combinations should be considered to be within the scope of the present specifications as long as there is no contradiction in the combinations of these technical features.

Merely several embodiments of the present disclosure are described above, and the descriptions thereof are specific and detailed. It should be understood that they are not construed as limiting the scope of the present disclosure. It should be noted that those skilled in the art may make some variations and improvements without departing from the concept of the present disclosure, and the variations and improvements shall be included in the protection scope of the present disclosure. Therefore, the protection scope of the present disclosure shall be subject to the protection scope defined by the appended claims.

## Claims

1. A color solar cell (10), comprising: a cell unit (20); and an anti-reflection layer (500) disposed on the cell unit (20) and configured to display a color pattern.

2. The color solar cell (10) according to claim 1, wherein the anti-reflection layer (500) comprises: a first anti-reflection layer (510) and a second anti-reflection layer (520); and the first anti-reflection layer (510) and the second anti-reflection layer (520) present different colors;
optionally, a pattern corresponding to the first anti-reflection layer (510) is different from a pattern corresponding to the second anti-reflection layer (520);
optionally, the cell unit (20) comprises: a substrate (100) and a function layer disposed on the substrate (100); wherein the anti-reflection layer (500) is disposed on the function layer.

3. The color solar cell (10) according to claim 2, wherein a plurality of the cell units (20) are provided; and
a sum of an area of the first anti-reflection layer (510) and an area of the second anti-reflection layer (520) is equal to an area of at least one of the cell units (20).

4. The color solar cell (10) according to claim 3, wherein the first anti-reflection layer (510) and the second anti-reflection layer (520) have different thicknesses;
optionally, the first anti-reflection layer (510) and the second anti-reflection layer (520) are made of different materials.

5. The color solar cell (10) according to any one of claims 1-4, wherein the anti-reflection layer (500) is made of SixNy, and a value range of x:y is 0.75∼4:1.

6. The color solar cell (10) according to any one of claims 1-5, wherein the cell unit (20) comprises: a substrate (100) and a function layer disposed on the substrate (100), and the anti-reflection layer (500) is disposed on the function layer; or,
the cell unit (20) comprises: a substrate (100) on which the anti-reflection layer (500) is disposed; and a function layer disposed on the anti-reflection layer (500).

7. The color solar cell (10) according to claim 6, wherein the function layer comprises: a back electrode layer (200) disposed on the substrate (100); a semiconductor layer (300) disposed on the back electrode layer (200); a conductive layer (400) disposed on the semiconductor layer (300); and a connection part (350) penetrating through the semiconductor layer (300), one end of the connection part (350) being electrically connected with the back electrode layer (200) and the other end of the connection part (350) being electrically connected with the conductive layer (400); wherein the anti-reflection layer (500) is disposed on the conductive layer (400); or,
the function layer comprises: a back electrode layer (200) disposed on the anti-reflection layer (500) on the substrate (100); a semiconductor layer (300) disposed on the back electrode layer (200); a conductive layer (400) disposed on the semiconductor layer (300); and a connection part (350) penetrating through the semiconductor layer (300), one end of the connection part (350) being electrically connected with the back electrode layer (200) and the other end of the connection part (350) being electrically connected with the conductive layer (400).

8. A preparation method for a color solar cell, comprising:
providing a cell unit (S10); and
forming an anti-reflection layer on the cell unit, wherein the anti-reflection layer is configured to display a color pattern (S20).

9. The preparation method for a color solar cell according to claim 8, wherein forming an anti-reflection layer on the cell unit comprises:
providing a template having at least one hollowed-out pattern, and depositing the anti-reflection layer on the cell unit by taking the template as a shield.

10. The preparation method for a color solar cell according to claim 9, wherein providing a template and depositing the anti-reflection layer on the cell unit by taking the template as a shield comprises:
providing a first sub-template having at least one hollowed-out first sub-pattern, and depositing a first anti-reflection layer on the cell unit by taking the first sub-template as a shield (S201); and
providing a second sub-template having at least one hollowed-out second sub-pattern, and depositing a second anti-reflection layer on the cell unit by taking the second sub-template as a shield (S202); wherein
the first anti-reflection layer and the second anti-reflection layer present different colors.

11. The preparation method for a color solar cell according to claim 10, wherein the second sub-pattern is complementary to the first sub-pattern;
a plurality of the cell units are provided, and a sum of an area of the second sub-pattern and an area of the first sub-pattern is equal to an area of at least one of the cell units.

12. The preparation method for a color solar cell according to claim 10, wherein after the step S202, the method further comprises:
providing a third sub-template having at least one hollowed-out third sub-pattern, and depositing a third anti-reflection layer on the cell unit by taking the third sub-template as a shield (S203); wherein
the first anti-reflection layer, the second anti-reflection layer and the third anti-reflection layer present different colors.

13. The preparation method for a color solar cell according to claim 12, wherein the first sub-pattern, the second sub-pattern and the third sub-pattern are complementary to each other;
a plurality of the cell units are provided, and a sum of an area of the first sub-pattern, an area of the second sub-pattern and an area of the third sub-pattern is equal to an area of at least one of the cell units.

14. The preparation method for a color solar cell according to claim 8, wherein the anti-reflection layer is formed through a chemical vapor deposition (CVD) process; and
a thickness of the anti-reflection layer is controlled by controlling deposition velocity or deposition time.

15. The preparation method for a color solar cell according to claim 8, wherein the step S10 comprises:
providing a substrate, forming a back electrode layer on a surface of the substrate, and performing a first etching on the back electrode layer to form a plurality of spaced back electrodes (S101);
depositing a semiconductor layer in spaces between adjacent back electrodes and on surfaces of the back electrodes, and performing a second etching on the semiconductor layer to enable the semiconductor layer to form a plurality of spaced semiconductor blocks, each of the semiconductor blocks being in contact with two of the back electrodes (SI02);
depositing a conductive material in spaces between adjacent semiconductor blocks and on surfaces of the semiconductor blocks to form a connection part and a conductive layer, wherein one end of the connection part is electrically connected with the conductive layer, and the other end of the connection part is electrically connected with the back electrode layer (SI03); and
performing a third etching on the conductive layer and the semiconductor layer to form a plurality of cell units connected in series (S104).
